Europäisches Patentamt

European Patent Office

Office européen des brevets

(19)

(11) Numéro de publication: **0 012 044**
**B1**

(12) **FASCICULE DE BREVET EUROPEEN**

(45) Date de publication du fascicule de brevet: **16.09.81**

(21) Numéro de dépôt: **79400760.9**

(22) Date de dépôt: **17.10.79**

(51) Int. Cl.³: **H 03 K 17/96**, H 03 J 5/02, H 04 N 5/00

(54) **Commutateur électronique à commande tactile et sélecteur de canaux comportant un tel commutateur.**

(30) Priorité: **24.11.78 FR 7833285**

(43) Date de publication de la demande:
**11.06.80 Bulletin 80/12**

(45) Mention de la délivrance du brevet:
**16.09.81 Bulletin 81/37**

(84) Etats Contractants Désignés:
**DE GB IT**

(56) Documents cités:
**US - A - 3 720 876**
**US - A - 3 798 463**

**WIRELESS WORLD, vol. 80, n° 1466,
octobre 1974,
Haywards Heath, Sussex (GB)
HINCH: "Self-cancelling touch button
control" page 380**

(73) Titulaire: **"THOMSON-BRANDT"**
**173, bld Haussmann**
**F-75360 Paris Cedex 08 (FR)**

(72) Inventeur: **Geiger, Erich**
**"THOMSON-CSF" - SCPI 173, bld Haussmann**
**F-75360 Paris Cedex 08 (FR)**

(74) Mandataire: **Schmolka, Robert et al,**
**"THOMSON-CSF" - SCPI 173. bld Haussmann**
**F-75360 Paris Cedex 08 (FR)**

Commutateur électronique à commande tactile et sélecteur de canaux comportant un tel commutateur

La présente invention concerne des commutateurs électroniques à commande tactile, applicables notamment, dans un sélecteur de canaux d'un récepteur de télévision dans lequel on utilise des diodes à capacité variable pour accorder les circuits résonnants de l'oscillateur local et des étages haute-fréquence (tuner).

Les commutateurs électroniques à commande tactile ou au toucher (appelés "sensor" dans la littérature anglo-américaine) comportent généralement deux électrodes isolées l'une de l'autre, permettre d'être galvaniquement réunies par la résistance de la peau (du doigt) de l'utilisateur. Dans un tel commutateur, l'une des électrodes est généralement reliée à la borne positive d'une source de tension continue et l'autre électrode est reliée, par l'interemédiaire d'une résistance, à l'entrée d'un amplificateur à courant continu de gain élevé (genre comparateur de tension analogique), dont la sortie bascule d'un premier état (haut, par exemple) dans un second état (bas, par exemple), lorsque les deux électrodes sont simultanément mises en contact à travers la peau du doigt de l'utilisateur dont la résistance ohmique de l'ordre de quelques mégohms permet d'injecter dans l'entrée de l'amplificateur un courant de quelques centaines de nanoampères.

Un certain nombre de commutateurs électroniques à commande tactile de ce genre ont été décrits dans les brevets des Etats-Unis d'Amérique Nos. 3.737.670, 3.766.404, 3.805.086, 3.879.618 et dans les brevets français Nos. 2.148.749 et 2.187.188, par exemple.

Les commutateurs électroniques à commande tactile peuvent comprende plusieurs circuits interrupteurs élémentaires comportant chacun en casade un circuit de commande et un interrupteur électronique (transistor, thyristor, triac), dont le premier comprend en cascade un étage "senseur" du type comparateur de tension et un étage de "mémoire" en forme de basculeur bistable alimentant l'électrode de commande (base, grille, gâchette) de l'interrupteur qui permet de réunir une charge aux bornes d'une source de tension d'alimentation, lorsqu'il est activé (saturé). De nombreux commutateurs de ce type utilisant des lampes à décharge gazeuse (à néon, par exemple) simultanément en tant qu'élément comparateur à seuil et basculeur bistable, ont été décrits dans les brevets français Nos. 2.047.155, 2.179.979 ou dans les brevets des Etats-Unis d'Amérique Nos. 3.503.018, 3.746.886, 3.828.205, qui présentent l'inconvénient de nécessiter des tensions d'amorçage élevées, incompatibles avec les normes de sécurité actuellement en vigueur.

Dans le brevet des Etats-Unis d'Amérique No. 3.798.468 ou britannique correspondant No. 1.415.199, on utilise des basculeurs bistables intégrés à transistors à effet de champ à grilles isolées, dont le basculement est déclenché à l'aide d'un signal de commande tactile appliqué à une entrée du basculeur et d'une impulsion d'horloge déclenché par ce signal tactile appliquée à une autre entrée de celui-ci, une pluralité de circuits intégrés logiques comprenant des portes ET et OU permettent l'activation alternée des basculeurs bistables.

Un autre type de commutateur sensible au toucher a été décrit dans le brevet français No. 2.227.686 ou britannique correspondant No. 1.443.094, dans lequel chaque module comprend un amplificateur d'entrée activé par le toucher, alimentant l'entrée de mise à un d'un basculeur bistable par une sortie et une ligne commune de remise à zéro des autres basculeurs par une autre sortie.

Dans le brevet des Etats-Unis d'Amérique No. 3.720.876 de MONTGOMERY, intitulé "TOUCH-BUTTON ACTUATED ELECTRONIC LATCHING DEVICE WITH MEANS FOR ENSURING LATCH OPERATION UPON THE APPLICATION OF POWER", on a décrit un commutateur commandé par des interrupteurs à boutons-poussoirs assurant un contact galvanique temporaire et comprenant également des basculeurs bistables de verrouillage (mémoire) à transistors complémentaires, associés par une résistance émetteur commune pour la commutation et comprenant un condensateur shuntant l'une des interrupteurs de commande pour l'activation préférentielle de l'un des basculeurs à la mise sous tension. L'activation des basculeurs est effectuée ici à l'aide de boutons-poussoirs à contact galvanique direct, et sans contact avec l'utilisateur, le déclenchement des basculeurs nécessitant ici un courant relativement important du fait que les transistors NPN qui sont rendus conducteurs d'abord, comprennent dans leurs circuits émetteurs la résistance commune, de sorte que la sensibilité du déclenchement est faible.

Dans un article de HINCH dans la revue britannique "WIRELESS WORLD", à la page 380 du No. 1 466, du volume 80, datée d'octobre 1974, intitulé "SELF-CANCELLING TOUCH BUTTON CONTROL", on a décrit un commutateur à commande par le toucher comportant un basculeur bistable de verrouillage à deux transistors complémentaires dont l'un de type PNP est directement commandé par la paire d'electrodes associée pour sa mise en conduction, le collecteur de ce transistor PNP étant directement réuni à la base de l'autre transistor du type NPN dont le collecteur constituant la sortie commutée, est réuni à la base du premier par un diviseur de tension résistif afin de provoquer le basculement par effet cumulatif. Les émetteurs respectifs de tous les transistors PNP sont réunis ensemble et par l'intermédiaire d'une résistance commune à la borne d'alimentation positive des basculeurs, afin que la mise en conduction d'un nouvel basculeur provoque la coupure de celui qui était conducteur auparavant. L'une des paires d'électrodes accessibles au toucher est shuntée par un condensateur afin de commander la mise en conduction préférentielle du basculeur associé à chaque mise sous tension.

Dans le circuit de l'article de HINCH précité, correspondant au préambule de la revendication 1, le transistor PNP a sa base reliée à l'un des électrodes de contact qui est réunie à la masse par la peau du doigt de l'utilisateur et le transistor NPN dont l'emetteur est relié à la masse constitue en même temps l'interrupteur électronique du faite que son collecteur peut être directement relié à l'une des bornes d'une charge dont l'autre borne est reliée au pôle positif d'une source de tension continue. Dans ce circuit, il n'y a de ce fait pas de moyens prévus, permettant de programmer la sensibilité au déclenchement du basculeur à transistors complémentaires.

Le commutateur électronique à commande tactile, objet de l'invention, permet au contraire de programmer la sensibilité de façon à permettre l'association d'un grand nombre d'éléments de commutation en assurant la sécurité du fonctionnement et la protection de l'usager contre des tensions élevées.

L'invention s'applique à un commutateur électronique à commande tactile, du type dans lequel la mise en contact galvanique par la résistance de la peau d'une paire d'électrodes de commande isolées l'une de l'autre et accessibles au toucher permet de provoquer la fermeture d'un interrupteur électronique actif à semiconducteur en appliquant à sa jonction d'entrée un courant qui l'amène à la saturation, comprenant un basculeur bistable de stockage à deux transistors complémentaires à rapport de transfert direct de courant élevé dans lequel le collecteur du premier transistor est réuni par l'intermédiaire d'un premier diviseur de tension résistif au premier pôle d'une première source de tension d'alimentation continue, ce premier pôle étant réuni par l'intermédiaire d'une troisième résistance à l'émetteur du second transistor dont la base est reliée au point milieu du premier diviseur et dont le collecteur est relié à la base du premier transistor qui est également réunie à l'une des électrodes de la paire dont l'autre électrode est réunie au premier pôle de la première source par l'intermédiaire d'une quatriéme résistance. Selon l'invention, l'émetteur du second transistor est également réuni, par l'intermédiaire d'une cinquième résistance formant avec la troisième résistance un second diviseur de tension résistif, au collecteur du premier transistor et les premier et second diviseurs forment ensemble un pont résistif déséquilibré, alimenté par le courant collecteur du premier transistor et permettant, par le choix des valeurs respectives de ses quatre résistances constitutives, de programmer la sensibilité du basculeur bistable.

L'invention sera mieux comprise et d'autres de ses caractéristiques et avantages apparaîtront de la description ci-après et des dessins annexés, donnés à titre d'exemple, sur lesquels:

—la figure 1 représente le schéma de principe d'une "cellule" ou d'un circuit élémentaire du commutateur suivant l'invention,

—la figure 2 est le schéma de principe de deux "cellules" groupées ensemble permettant de commuter deux circuits d'utilisation, et

—la figure 3 représente le schéma de principe d'un ensemble regroupant six commutateurs à commande tactile pour former un sélecteur de canaux d'un récepteur de télévision dont l'oscillateur local et les étages hautefréquence ("tuner") sont accordés à l'aide de diodes à capacité variable.

Sur toutes les figures, les mêmes éléments ont été désignés par les mêmes nombres de repère (le premier chiffre indiquant le rang du circuit élémentaire).

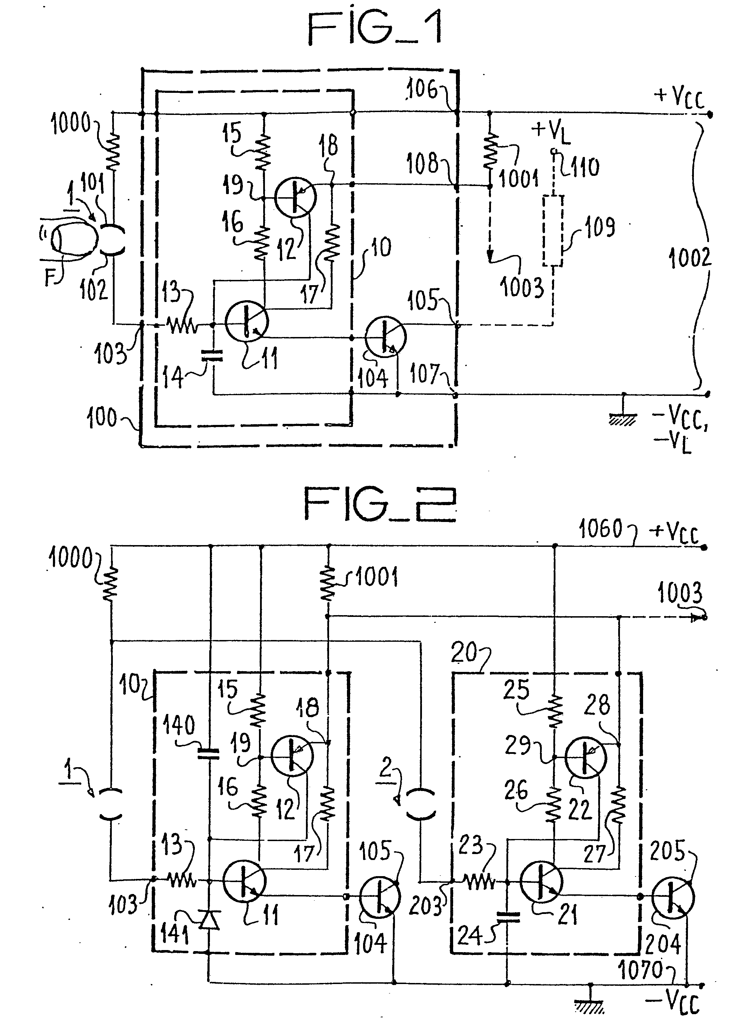

Sur la figure 1, représentant le schéma de principe d'un élément ("cellule") interrupteur électronique à commande tactile 100, on a représenté en 1 la paire d'électrodes 101, 102 devant être réunies ensemble par la peau du doigt F de l'utilisateur. Elles sont représentées ici sous la forme de deux arcs de cercle de même rayon, diamétralement opposés, mais elles peuvent prendre toute forme connue, notamment celles des brevets précités. Elles sont montées dans un support isolant (non représenté) dont elles émergent à la surface pour permettre leur mise en liaison galvanique par la peau. La première électrode 101 est reliée au pôle positif $(+ V_{cc})$ d'une source de tension continue éventuellement à travers une résistance 1000 dont la valeur (de l'ordre de 100 kiloohms) est choisie en fonction de cette tension, de façon à protéger l'utilisateur contre une électrocution en limitant le courant qui le parcourt, lorsque l'utilisateur est réuni à la masse. La seconde électrode 102 est reliée à l'entrée de commande 103 de l'élément interrupteur de base 100 qui comprend, en outre, deux entrées (bornes) d'alimentation 106 et 107 respectivement reliées aux pôles positif $(+ V_{cc})$ et négatif $(- V_{cc})$ d'une source de tension continue d'alimentation 1002 qui alimente ici également la première électrode 101. Toutefois, on peut relier cette électrode 101 au pôle positif d'une autre source de tension qui peut être supérieure à $V_{cc}$ à condition de réunir les pôles négatifs de ces deux sources ensemble à la masse.

Un tel élément interrupteur 100 suivant l'invention remplit les trois fonctions des circuits intégrés de la technique antérieure qui comprennent en cascade:

a) un étage "senseur" ou amplificateur de commutation à gain élevé, c'est-à-dire à basculement d'un premier état (bloqué) dans un second état (conducteur ou saturé) lorsque sa tension d'entrée s'élève suite à la mise en contact galvanique simultanée des deux électrodes par l'utilisateur,

b) un étage de mémoire binaire stockant l'information transmise par le senseur jusqu'à ce qu'il reçoive un signal de sa remise à l'état initial, et

c) un étage interrupteur commandé par la mémoire de façon à être ouvert (bloqué) lorsque la mémoire est dans son état initial et fermé (saturé), lorsque la mémoire a basculé sous l'effet du passage du seuseur de son premier à son second état.

Le circuit électronique de commande 10 formé par les étages amplificateur ou "senseur" et de mémoire en cascade, est réalise ici à l'aide d'un étage unique à deux transistors 11 et 12 complémentaires qui forment un circuit connu sous le nom de basculeur bistable de stockage (appelé "complementary transistor bistable latch" dans la littérature anglo-américaine). Un tel circuit est équivalent à un circuit basculeur comprenant un thyristor (PNPN) de type tétrode ayant des gâchettes d'anode et de cathode accessibles, (voir, par exemple, dans la demande de brevet français antérieure No. 2 261 670 déposée le 15 février 1974 par la demanderesse).

Le circuit basculeur à transistors complémentaires 10 commande un étage interrupteur électronique constitué ici par un troisième transistor de commutation de type NPN 104, dont la base est réuni à la sortie du basculeur 10 et dont l'émetteur est réuni à la seconde borne d'alimentation 107 du circuit interrupteur élémentaire 100. Le collecteur du troisième transistor 104 constituant la sortie 105 du circuit interrupteur 100, est relié à travers une charge 109 à la borne d'alimentation 110 de la charge 109, qui est reliée au pôle positif $(+ V_L)$ d'une seconde source de tension d'alimentation dont le pôle négatif $(- V_L)$ doit être également relié à la borne 107. Le troisième transistor 104 qui constitue l'élément interrupteur, est unidirectionnel, c'est-à-dire qu'il ne peut servir à commuter qu'une tension continue; il peut être remplacé par d'autres éléments semiconducteurs actifs à conduction commandée, tel qu'un thyristor qui peut être monté en antiparallèle avec une diode si l'on désire commuter une tension alternative ou un triac, de la façon décrite et illustrée dans le brevet des Etats-Unis d'Amérique No. 3.798.462 où ce triac est commandé par un circuit basculeur à transistors complémentaires dont le déclenchement alternatif à commande tactile est toutefois différent de celui du circuit 10.

Dans le circuit interrupteur élémentaire 100 suivant l'invention, le basculeur bistable de stockage 10 est équipé d'un premier transistor 11 de type NPN, dont le rapport de transfert de courant en émetteur commun $h_{21E}$ est élevé $(\geqslant 200$ de préférence) pour assurer au circuit 10 une sensibilité élevée, et qui est monté en émetteur commun. L'émetteur de ce premier transistor 11 qui constitue la sortie du basculeur 10, est, de préférence, directement réuni à la base du troisième transistor 104 et donc, à travers la jonction base-émetteur de ce dernier, à la borne 107 (masse).

Le collecteur du premier transistor 11 est relié, par l'intermédiaire de deux diviseurs de tension résistifs, respectivement composés d'une première 16 et seconde 15 résistances en série et d'une troisième 17 et quatrième 1001 résistances en série, montés en parallèle, à la première borne d'alimentation 106 $(+ V_{cc})$ du circuit interrupteur 100. Les trois résistances 15, 16 et 17 peuvent être de même valeur (plusieurs dizaines de kiloohms, par exemple) et la quatrième 1001 est d'une valeur différente, inférieure à celle des trois premières, pour former un pont déséquilibré aux points communs 19 et 18 respectifs des résistances 15 et 16 et 17 et 1001.

Un second transistor 12 de type PNP, dont le rapport de transfert de courant $h_{21E}$ est comparable à celui du premier 11, est également monté en émetteur commun, avec son émetteur réuni à la jonction 18 de la troisième 17 et quatrième 1001 résistances. La base de ce second transistor 12 est reliée à la jonction 19 des première 16 et seconde 15 résistances et son collecteur à la base du premier transistor 11.

La commande du circuit basculeur 10 pour le faire basculer de son état bloqué à son état saturé, est effectuée par la polarisation positive de la base du premier transistor 11 à travers la résistance de la peau de l'opérateur qui appuie son doigt F sur les deux électrodes 101, 102. A cette fin, l'entrée de commande 103 du circuit interrupteur 100 est réunie à la base du premier transistor 11 à travers une résistance d'entrée 13 de valeur élevée (supérieure à plusieurs centaines de kiloohms) qui protège le transistor 11 et qui fait partie d'un filtre passe-bas d'entrée en conjonction avec un condensateur d'entrée 14 réunissant la base de ce dernier à la masse (107) pour éliminer la tension alternative induite dans l'utilisateur par des sources haute-fréquence ou par le réseau alternatif d'alimentation électrique (220 V, 50 Hz).

A la mise sous tension des bornes d'alimentation 106 et 107 du circuit interrupteur 100, les deux transistors 11, 12 sont bloqués du fait que la base du premier 11 ne reçoit aucune tension de polarisation. Lorsque le doigt F appuie sur les électrodes 101, 102 de la paire 1, le condensateur d'entrée 14 commence à se charger positivement par la borne 106 $(+ V_{cc})$, à travers les résistances 1000, 13 et celle de la peau $R_F$ en série. Lorsque la tension aux bornes du condensateur 14 atteint la valeur de déploquage de la tension base-émetteur

$V_{BE11}$ du premier transistor 11, celui-ci commence à conduire en provoquant par son courant collecteur $I_{C11}$ des chutes de tension aux bornes des résistances 15, 16, 17 et 1001 formant les deux diviseurs de tension montés en parallèle. Dès que la tension collecteur-émetteur $V_{CE11}$ du premier transistor 11 tombe en-dessous d'une valeur pour laquelle la différence de potentiel entre les fonction 18 et 19 (points milieu des diviseurs, formant une diagonale du pont déséquilibré), auxquelles sont respectivement reliés l'émetteur et la base du second transistor 12, dépasse la valeur de déblocage de sa tension émetteurbase $V_{EB12}$, celui-ci commence à conduire en injectant son courant collecteur $I_{C12}$ dans la base du premier transistor 11. Le courant collecteur du second transistor 12 s'ajoutant ainsi au courant de base du premier transistor 11 provenant de la borne positive 106 à travers la résistance du peau $R_F$ réunissant la paire d'électrodes 1, entraîne une augmentation de son courant collecteur $I_{C11}$ et, par conséquent, de la tension négative de polarisation base-émetteur $V_{BE12}$ du second transistor 12 de façon à augmenter son courant-collecteur $I_{C12}$.

L'effet cumulatif des augmentations des courants collecteurs respectifs des deux transistors 11, 12, amène le premier 11 jusqu'à la saturation. La valeur des résistances 15, 16, 17 et 1001 doit être calculée de façon à permettre au premier transistor 11 de fournir, à l'état saturé, un courant émetteur $I_{E11}$ suffisant pour amener le troisième transistor 104 à saturation. La sensibilité du circuit 10 suivant l'invention, qui est en même temps un "senseur" (amplificateur de commutation) et une "mémoire", peut être programmée par le choix des valeurs des résistances 15, 16, 17 et 1001 du pont déséquilibré.

En choisissant les valeurs des résistances 15, 16 et 17 (égales à 68 kiloohms) et celle de la résistance 1001 (égale à 47 kiloohms), on peut calculer le courant collecteur $I_{C11}$ correspondant à la saturation du premier transistor ainsi que le courant de base $I_{B11}$ nécessaire pour l'y amener.

Le courant collecteur $I_{C11}$ de saturation est égal à la différence entre la tension d'alimentation ($|V_{cc}|$) et la tension de saturation collecteur-émetteur ($V_{CE11sat}$) du transistor 11 divisée par la résistance équivalente du réseau diviseur ($I_{C11}$ est d'environ 170 microampères). En divisant la valeur $I_{C11}$ ainsi obtenue par le rapport de transfert de courant en émetteur commun $h_{21E11}$ (de l'ordre de 200) on obtient le courant de base $I_{B11}$ nécessaire à sa saturation ($I_{B11} = 0,8\ \mu A$). Pour que le second transistor 12 maintienne le premier 11 en saturation, il suffit que $I_{C12} = I_{B11}$. Il est donc possible de calculer la tension émetteur-base $V_{EB12}$ entre les jonctions 18 et 19 nécessaire pour que $I_{C12}$ soit de 800 nanoampères au moins. Ce calcul selon une formule classique

$$V_{EB} = \frac{kT}{q_e} \cdot \ln\left(\frac{I_c}{I_{ES}} + 1\right),$$

où k est la constante de Boltzmann, T la température en degrés Kelvin, $q_e$ la charge d'un électron, $I_C$ le courant collecteur et $I_{ES}$ le courant de saturation émetteur-base avec collecteur relié à la base. Ceci donne une tension $V_{EB12}$ de 0,5 environ.

A partir de cette valeur on peut calculer le courant collecteur $I_{C11F}$ suffisant pour faire basculer le basculeur 10 de son état bloqué à son état saturé, en calculant d'abord la tension alimentant la première diagonale du pont déséquilibré, nécessaire pour obtenir sur sa seconde diagonale entre les jonctions 18 et 19 une différence de potentiel égale à $V_{BE12} = 0,5$ V.

Ce calcul donne une différence entre la tension d'alimentation ($V_{CC}$) et la tension collecteur du transistor 11 ($V_{C11}$) d'environ 6 V. En divisant cette valeur ($V_{CC} - V_{C11}$) par le résistance équivalente du pont dans le circuit collecteur du transistor 11, on obtient le courant collecteur de basculement $I_{C11F}$ et en divisant celui-ci par le rapport de transfert de courant $h_{21E11}$, on obtient le courant de base $I_{B11F}$ minimal pour faire basculer le circuit 10 (pour $I_{C11F}$ de 100 microampères environ on obtient $I_{B11F}$ de 500 nanoampères). De là, on peut calculer la résistance maximale de peau $R_{FM}$ permettant de commander le basculement, qui est égale à la différence entre la tension d'alimentation ($V_{CC}$) et la tension base-émetteur $V_{BE11}$ (de 0,6 V environ) correspondant au courant $I_{C11F}$, divisée par le courant de base $I_{B11F}$. Ceci donne une résistance de peau $R_{FM}$ inférieure à 21 mégohms environ.

On peut alors vérifier par un calcul simple (en mettant $V_{EB12} = 0,7$ V), que le second transistor 12 constitue une source de courant collecteur largement suffisant pour maintenir le premier transistor 11 à l'état saturé. On peut voir également qu'une tension d'alimentation $V_{CC}$ supérieure ou égale à 6 V environ est suffisante pour que le maintien en saturation du circuit basculeur 10 soit assuré.

On remarquera ici que, pour remettre le circuit basculeur 10 dans son état initial (bloqué), il suffit de bloquer le second transistor 12 en mettant son émetteur à un potentiel inférieur ou égal à celui de sa base, par exemple, en reliant la sortie 108 du circuit 100 à la masse à l'aide d'un interrupteur 1003 (non représenté).

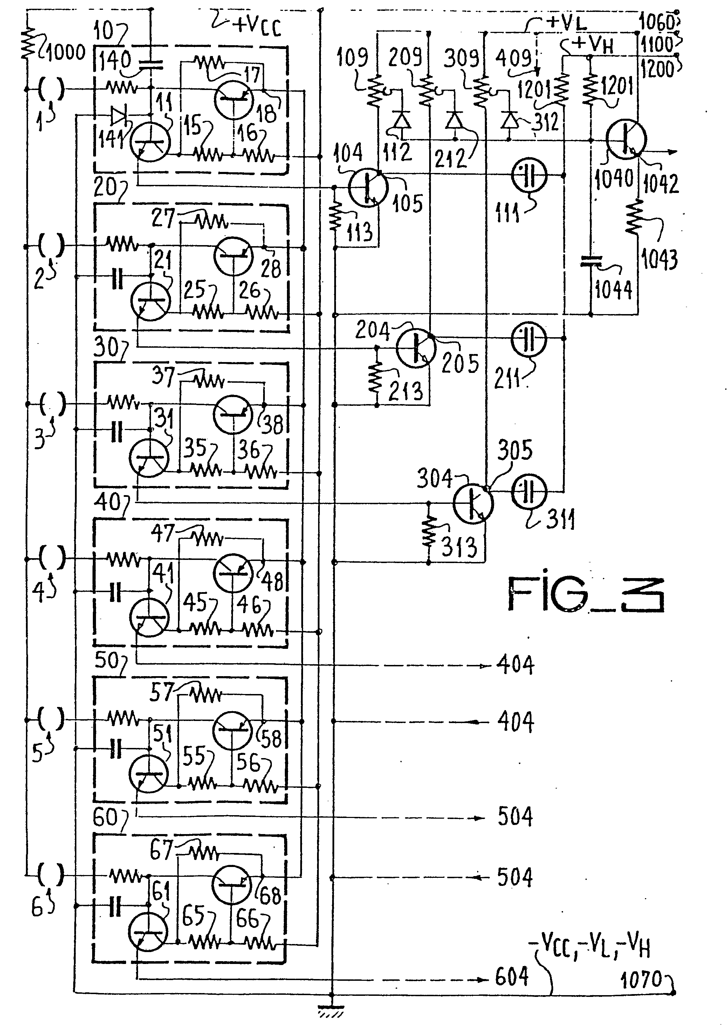

Sur la figure 2, on a représenté le schéma de principe d'un commutateur électronique suivant l'invention, à deux interrupteurs du type de celui de la figure 1, agencé de manière à commuter de façon alternée deux charges. Plus précisement, le commutateur de la figure 2 comporte deux circuits "senseurs" à basculeurs complémentaires 10 et 20 connectés ensemble de sorte que le basculement de l'un de son premier état dans son second état provoque basculement de l'autre de son second état à son premier état. Les composants du second basculeur 20, identiques à ceux du basculeur 10 de la figure 1, sont désignés par des nombres de repère dont le premier chiffre (2) indiqué leur appartenance et dont le second chiffre est le même que celui du basculeur 10.

Chacun des interrupteurs élémentaires du circuit de la figure 2 a son entrée de commande 103, 203 reliée à travers une paire d'électrodes à connection tactile 1, 2 et une résistance de protection commune 1000 à la première borne d'alimentation 1060 ($+ V_{CC}$). Le retour à l'état bloqué du basculeur saturé, lorsque l'autre basculeur initialement bloqué est commandé par le doigt de l'opérateur pour conduire, est obtenu à l'aide d'une résistance 1001 commune aux deux basculeurs 10 et 20, à travers laquelle les deux émetteurs de leurs seconds transistors 12 et 22 sont réunis ensemble à la borne d'alimentation positive 1060.

Dans le premier circuit basculeur 10, on a connecté le condensateur d'entrée 140 entre la borne d'alimentation positive et la base du premier transistor NPN 11, cette base étant, d'autre part, reliée à la cathode d'une diode 141 dont l'anode est reliée à la seconde borne d'alimentation 1070 (masse). Ceci a pour effet de déclencher le basculement du premier basculeur 10 dès sa mise sous tension, car le condensateur 140 initialement déchargé transmet à la base du transistor 11, lors de l'établissement de la tension d'alimentation $V_{CC}$, son courant de charge qui traverse la diode formée par la jonction base-émetteur de ce transistor 11 (en série avec celle formée par la jonction base-émetteur du troisième transistor de commutation 104). Le courant de charge du condensateur 140 qui décroît rapidement avec sa charge croissante, suffit pour rendre conducteur le premier transistor 11 d'abord et le second transistor 12 ensuite et pour amorcer le basculement régénératif du circuit 10 vers l'état saturé.

La diode 141, qui est branchée en antiparallèle avec la jonction base-émetteur du premier transistor 11, permet de décharger le condensateur d'entrée 140 lors de d'arrêt de l'alimentation continue ($V_{CC}$ tend vers zéro) pour que l'on puisse obtenir de nouveau un courant de base initial dans le premier transistor 11, lors de la remise en marche de l'alimentation continue.

Le premier circuit basculeur 10 étant saturé dès sa mise sous tension, le courant $I_{1001}$ qui parcourt la résistance commune 1001 provoque aux bornes de celle-ci une chute de tension $V_{CC} - V_{18} = R_{1001}.I_{1001}$ qui polarise les émetteurs des deux seconds transistors 12 et 22. Ce courant $I_{1001}$ se compose de la somme du courant émetteur $I_{E12}$ du transistor 12 et du

courant $I_{17}$ dan la résistance 17 (vers le collecteur du transistor 11). Lorsque l'on déclenche le second basculeur 20 en posant le bout du doigt sur la paire d'électrodes 2, le premier transistor 21 de ce circuit se met à conduire et son courant collecteur $I_{c21}$ comprendra une composante $I_{27}$ parcourant la troisième résistance 27, qui s'ajoute à la somme de $I_{E12}$ et $I_{17}$ de façon à augmenter le courant $I_{1001}$ et, par conséquent, également la chute de tension aux bornes de la résistance commune 1001 de façon à réduire la tension émetteur-base $V_{EB12}$ du second transistor 12 du premier circuit 10. Ceci a pour effet de réduire le courant collecteur $I_{C12}$ du second transistor 12 qui constitue le courant de base $I_{B11}$ du premier transistor 11 et donc également le courant collecteur $I_{C11}$ de celui-ci. La diminution du courant collecteur $I_{C11}$ du premier transistor 11 qui cesse d'être saturé, réduit la chute de tension aux bornes de la résistance 15 du premier diviseur 15, 16 entraînant une diminution supplémentaire de la tension $V_{EB12}$, avec effet cumulatif jusqu'à la coupure des courants collecteurs $I_{C12}$ et $I_{C11}$ entraînant également une cessation du courant $I_{17}$ dans la troisième résistance 17.

La chute de tension aux bornes de la résistance commune 1001, engendrée alors uniquement par le courant $I_{27}$ dans la troisième résistance 27 du second basculeur 20, diminue et, le premier transistor 21 conduisant, la tension émetteur-base $V_{EB22}$ du second transistor 22 prise entre les points 28 et 29 s'accroît suffisamment pour que celui-ci se mette à conduire et amène le premier transistor 21 jusqu'à la saturation. L'ensemble des résistances 15, 16 et 17 du premier basculeur 10 en série est alors connecté en parallèle avec la résistance commune 1001 de sorte que le sens (signe) du courant $I_{17}$ est inversé. Ceci s'applique également aux résistances 25, 26 et 27, lorsque le premier basculeur 10 est saturé et le second bloqué.

Si l'on considère que l'un des senseurs-basculeurs 10, 20 est toujours conducteur et que les résistances 15, 16, 17 et 25, 26, 27, ont sensiblement la même valeur, on peut écrire en ce qui concerne la différence de potentiel entre les émetteurs des seconds transistors 12, 22 et la masse ($-V_{cc}$),

$$\text{que } V_{E12} = V_{E22} = \frac{V_{CC} - V_{CE\,sat}}{2} - V_{EB}.$$

Si l'on rend le premier transistor 21 du second basculeur 20 conducteur afin que le courant $I_{27}$ parcourant la résistance 27 soit égale au courant émetteur $I_{E12}$ du second transistor 12 du premier basculeur 10, celui-ci se bloque car $V_{B12}$ s'approche alors de $V_{E12}$ et $V_{EB12}$ tend vers zéro. Le courant $I_{17}$ dans la résistance décroît pour passer par zéro vers une faible valeur négative qui peut s'écrire

$$-I_{17} = \frac{V_{cc} - V_{18}}{R_{15} + R_{16} + R_{17}}.$$

Cette inversion du courant $I_{17}$ a pour effet de ramener le potentiel des émetteurs $V_{E12}$, $V_{E22}$ de seconds transistors 12, 22 à sa valeur statique afin de permettre la mise en conduction du second transistor PNP 22, sa base étant alors polarisée négativement par rapport à son émetteur. Ceci constitue donc l'instant de l'inversion des états des deux basculeurs 10, 20.

On peut alors déterminer le courant collecteur $I_{C21i}$ suffisant pour produire cette inversion, qui définit la sensibilité de celle-ci. Le premier transistor 21 du second basculeur 20 doit alors conduire un courant collecteur $I_{C21}$ égal à la somme des courants dans la première branche 25, 26 du pont ($I_{25+26}$) et dans la résistance 27 ($I_{27}$) qui doit être supérieur ou égal au courant émetteur $I_{E12}$ du second transistor 12 du premier basculeur 10. Il a été mentionné précédemment, lors de la description de la figure 1, que pour rendre conducteur le second transistor (PnP) 12, 22 d'un basculeur, la tension aux bornes de la première diagonale du pont de résistances doit être au moins égale à 6 volts environ. D'où l'on obtient que, en mettant $V_{cc} - V_{C21} \geqslant 6\,V$, le courant $I_{C21}$ doit être supérieur ou égale à

$$\frac{V_{cc} - V_{C21}}{R_{25} + R_{26}} + I_{E12}$$

qui donne une valeur de 65 microampères environ. En mettant le rapport de transfert de courant $h_{21E} \geqslant 200$ on obtient pour $I_{B21} = I_{C21}/h_{21E}$ une valeur de quelque 350 nano-ampères. D'où l'on peut calculer la résistance maximale de la peau $R_{FM}$ qui dans ce cas, pour une tension $V_{cc} = 10\,V$, doit être inférieur à

$$\frac{10 - V_{BE21}}{I_{B21}} = \frac{9,4}{0,35}\,10^6,$$

c'est-à-dire à environ 27 mégohms.

De ce qui précède, on peut voir que la présence du premier basculeur 10 avec son condensateur d'entrée 140 entraînant une transition graduelle du courant $I_{17}$ dans le résistance 17 permet d'augmenter la sensibilité d'inversion du commutateur de la figure 2 par rapport à celle de l'interrupteur de la figure 1.

Lorsque le courant $I_{17}$ se stabilise suite à la décharge du condensateur 140, le courant collecteur $I_{C21}$ nécessaire à assurer l'inversion du commutateur à deux basculeurs redevient de l'ordre de 100 microampères, comme dans le cas de l'interrupteur 100 unique de la figure 1. Ceci n'a pas d'importance, car le second transistor 22 est déjà conducteur avec son courant collecteur $I_{C22}$ injecté dans la base du premier transistor 21 ($I_{C22} = I_{B21}$) du second "senseur" 20.

Cette sensibilité de commutation du circuit de la figure 2 dépend linéairement seulement du rapport de transfert direct de courant $h_{21E}$ des transistors équipant les basculeurs à transistors complémentaires 10, 20. Elle est largement suffisante, comme il a été démontré précédemment, pour des $H_{21E} \geqslant 200$ (ce qui est actuellement couramment garanti même pour des transistors de faible prix), où une résistance de peau $R_F$ de 25 M$\Omega$ permet de commuter avec une très grande sécurité en utilisant une tension d'alimentation de 10 volts. En augmentant la tension d'alimentation des premières électrodes des paires d'électrodes de commande 1, 2, on augmente d'autant la résistance de peau maximale. Il est donc possible de choisir des résistances d'entrée 13, 23 de l'ordre de un ou plusieurs mégohms ce qui a pour résultat de permettre à la surface isolante entourant les électrodes 1, 2, d'accumuler des charges statiques élevées (25 kV), sans que le courant de base maximal $I_{B\,max}$ des premiers transistors 11, 21 soit dépassé.

La figure 3 représente le schéma d'ensemble d'un commutateur électronique à commande tactile sextuple, destiné à équiper un sélecteur de canaux pour récepteur de télévision.

Comme il a été décrit précédemment et illustré sur la figure 2, dans un commutateur à N éléments il n'y a toujours qu'un seul des N interrupteurs qui est activé, lorsque l'on réunit ensemble les points 18, 28, 38, 48, 58, 68...n8, c'est-à-dire les émetteurs des seconds transistors 12, 22,...n2 du type PNP (N étant le nombre de "senseurs" et n leur numéro respectif). On a également mentionné que les trois résistances n5, n6 et n7 de tous les senseurs non-activés fournissent du courant à la résistance n7 du senseur activé, c'est-à-dire que leur montage série est en parellèle avec la résistance commune 1001. Il en découle que si l'on dispose du plus de quatre ($N \geqslant 4$) basculeurs n0, il est possible d'omettre la résistance commune 1001 en lui substituant le branchement parallèle des N—1 groupes de trois résistances n5, n6 et n7 en série. La troisième résistance n7 du n-ième basculeur n0 non-activé sera alors parcourue d'un courant négatif

$$-I_{n7} = \frac{V_{cc} - V_{n8}}{R_{n5} + R_{n6} + R_{n7}}.$$

Ces N—1 courants $-I_{n7}$ sont additionnés et leur somme est égale à la somme du courant émetteur du second transistor n2 et du courant dans la troisième résistance n7 du basculeur n0 activé.

Le commutateur électronique à commande tactile, illustré schématiquement sur la figure 3 est sextuple (N = 6), c'est-à-dire pourvu de six circuits interrupteurs élémentaires permettant de commuter six charges 109, 209, 309 ... 609 constituées ici par des potentiomètres dont l'une des bornes est reliée à la borne d'alimentation positive 1100 d'une seconde source de tension continue stabilisée ($V_L$ = 33 V) et dont les autres bornes sont respectivement reliées aux collecteurs 105, 205, 305, ... 605 des transistors de commutation 104, 204, 304, ... 604 constituant les sorties respectives de ces circuits interrupteurs élémentaires. Ces collecteurs 105, 205, 305, ... 605 sont par ailleurs respectivement réunis à des premières électrodes de six lampes de signalisation à décharge gazeuse (à néon) 111, 211, 311, ... 611 dont les secondes électrodes sont réunies ensemble et à travers une résistance 1201 de limitation de courant de valeur élevée (100 kiloohms), à la borne d'alimentation positive 1200 d'une troisième source de tension continue ($V_H$) de valeur suffisante pour amorcer ces lampes (+ 110 V) qui permettent d'indiquer lequel des basculeurs n0 a été activé et, par conséquent, lequel des potentiomètres n09 est alimenté. Ces lampes de signalisation n11 peuvent être placées derrière un panneau transparent dans lequel le chiffre n a été gravé, afin d'éclairer celui-ci. Il est également possible de réaliser le support isolant des paires d'électrodes 1, 2, ... n en matériau plastique transparent et de placer les lampes n11 respectivement derrière chaque paire d'électrodes. On peut également remplacer les lampes à néon n11 par les électrodes respectives d'un tube d'affichage de chiffres à décharge gazeuse, généralement appelé "nixie" dans la littérature anglo-américaine ou par un panneau d'affichage à diodes électroluminescentes.

Les six potentiomètres 109, 209, 309, ... 609 constituant respectivement des sources de tension de polarisation inverse réglables pour des diodes à capacité variable, dites "varicaps' (non représentées), qui permettent d'accorder des circuits résonnants (non représentés) de l'étage hautefréquence et de l'oscillateur local d'un récepteur de télévision, ont leurs curseurs respectivement réunis aux cathodes de six diodes de découplage 112, 212, 312, ... 612 dont les anodes sont réunies ensemble à la base d'un transistor du type NPN 1040 monté en collecteur commun qui permet d'alimenter les diodes varicap avec une impédance interne relativement faible et d'assurer la compensation en température des diodes 112, ... 612. La base du transistor 1040 est reliée à travers une résistance 1041 de valeur très élevée (de l'ordre d'un mégohm) à la borne positive d'une source de tension continue qui doit être supérieure à celle ($V_L$) alimentant les potentiomètres 109, 209, 309, ... 609 afin de fournir simultanément un courant de base au transistor 1040 et un courant de commutation (de polarisation positive) aux diodes de découplage. Dans le cas présent, on a choisi la troisième source dont la borne positive 1200 alimente les lampes de signalisation 111, 211, ... 611 ainsi que les étages de sortie de l'amplificateur vidéofréquence (non représenté) du récepteur de télévision.

Le collecteur du transistor 1040 est directement relié à la borne positive 1100 de la seconde source de tension $V_L$ alimentant les potentiomètres 109, ... 609 et son émetteur 1042, constituant la sortie d'accord du sélecteur de canaux, est relié par l'intermédiaire d'une résistance de charge 1043 (de plusieurs dizaines de kiloohms) à la seconde borne d'alimentation commune 1070 aux trois sources de tension continue, réunie à leurs pôles négatifs, ($-V_{cc}, -V_L, -V_H$), et reliée à la masse.

La base du transistor 1040 est, de préférence, également couplée à la masse (borne 1070) à l'aide d'un condensateur de filtrage 1044 de capacité élevée (0,1 microfarads), permettant un filtrage actif des ronflements (ondulations résiduelles) des tensions d'alimentation ($V_L, V_H$) fournies par les seconde et troisième sources.

Les premiers transistors 11, 21, ... 61 de chacun des basculeurs 10, 20, ... 60 ont leurs émetteurs respectivement directement réunis aux bases des transistors de commutation 104, 204, ... 604 dont les émetteurs sont reliés à la masse commune (borne 1070). Comme leur gain de courant est très élevé, ils peuvent amplifier très fortement des tensions de ronflement qui peuvent être appliquées aux entrées des basculeurs en produisant des courants de base $I_{Bn1}$ de l'ordre de quelques microampères (par exemple, à travers le condensateur d'entrée 140), qui sont insuffisants pour faire basculer les circuits 10, 20, ... 60 mais suffisent à produire des tensions indéfinies sur les collecteurs des transistors de commutation 104, 204, ... 604. Ceci peut être évité en branchant respectivement entre les bases et les émetteurs du ces derniers des résistances 113, 213, 313, ... 613 de valeur élevée (supérieure à 100 kiloohms).

On remarquera ici que, pour assurer la commutation des bandes de fréquences I (VHF), III et IV (UHF), on doit commuter des inductances des circuits résonnants du "tuner". Ceci peut être effectué à l'aide de trois transistors de commutation supplémentaires du type PNP (non représentés) dont les émetteurs sont réunis à la première borne d'alimentation positive 1060 (+ $V_{cc}$), par exemple, et dont les bases sont respectivement réunies à travers trois résistances et des contacts fixes de six commutateurs de sélection de bande à commande manuelle et à trois positions (non représentés), dont les six contacts mobiles sont respectivement couplés par six diodes de découplage (non représentés), aux six collecteurs 105, 205, ... 605 des transistors de commutation 104, 204, ... 604.

Dans le commutateur sextuple de la figure 3, toutes les résistances n5, n6, n7 des basculeurs n0 ont les mêmes valeurs (68 k $\Omega$). Toutefois, l'agencement très simple et peu coûteux du circuit élémentaire permet de réaliser des commutateurs avec un nombre quelconque d'interrupteurs. Il faut toutefois tenir compte du fait que les courants négatifs $-I_{n7}$ des basculeurs n0 non-activés s'additionnent dans la liaison commune des émetteurs des seconds transistors n2. Il est donc préférable de modifier les valeurs des résistances n5 = n6 et n7 pour des commutateurs à 8—12 ou à 16 interrupteurs.

Les critères du calcul ces résistances des basculeurs sont les suivants:

1) pour obtenir un comportement de saturation sensiblement identique des transistors de commutation n04, il faut conserver les valeurs des courants émetteurs des premiers transistors n1 des basculeurs n0 sensiblement les mêmes;

2) la somme des courants $-I_{n7}$ de tous les basculeurs non-activés ne doit pas augmenter sensiblement.

Le second critère a pour résultat l'augmentation de la valeur des résistances n5 et n6 avec le nombre N des interrupteurs, tandis que le premier critère résulte en une diminution de la valeur des troisièmes résistances n7.

Pour obtenir une sensibilité et une sécurité de maintien de l'état activé des basculeurs n0 sensiblement comparables à celles du commutateur sextuple de la figure 3, un calcul simple donnera, par exemple:

a) pour un commutateur à huit interrupteurs:
$R_{n5} = R_{n6} = 100$ k $\Omega$ et $R_{n7} = 56$ k $\Omega$ ;

b) pour un commutateur à douze interrupteurs:
$R_{n5} = R_{n6} = 180$ k $\Omega$ et $R_{n7} = 56$ k $\Omega$ ; et

c) pour un commutateur à seize interrupteurs:
$R_{n5} = R_{n6} = 270$ k $\Omega$ et $R_{n7} = 68$ k $\Omega$ .

De ce qui précède, on peut voir aisément que le commutateur électronique à commande tactile ou sensible au toucher, du type décrit, appliqué à des sélecteurs de canaux pour récepteurs de télévision télécommandables comportant des moyens pour être en état de veille, prêtes à recevoir et à répondre à des signaux de télécommande, présente l'avantage d'avoir une consommation électrique sensiblement nulle, lorsque tous les basculeurs bistables de stockage à transistors complémentaires sont non-activés, contrairement à ceux des sélecteurs comportant des basculeurs classiques ou à circuits intégrés. Par ailleurs, dans les commutateurs de l'art antérieur, il n'est pas possible de programmer la sensibilité du basculement au moyen du choix de la valeur de quelques résistances du pont déséquilibré en fonction des tensions disponibles et du gain en courant des transistors du basculeur.

## Revendications

1. Commutateur électronique à commande tactile, du type dans lequel la mise en contact galvanique par la résistance de la peau d'une paire (1) d'électrodes de commande (101, 102), isolées l'une de l'autre et accessibles au toucher permet de provoquer la fermeture d'un interrupteur électronique actif à semiconducteur (104) en appliquant à sa jonction d'entrée un courant qui l'amème à la saturation, comprenant un basculeur bistable de stockage (10) à deux transistors complémentaires (11, 12) á rapport de transfert direct de courant élevé dans lequel le collecteur du premier transistor (11) est réuni par l'intermédiaire d'un premier diviseur de tension résistif (15, 16) au premier pôle (+ Vcc) d'une première source de tension d'alimentation continue, ce premier pôle étant réuni par l'intermédiaire d'une troisième résistance (1001) à l'émetteur du second transistor (12) dont la base est reliée au point milieu (19) du premier diviseur (15, 16) et dont le collecteur est relié à la base du premier transistor (11) qui est également réunie à l'une (102) des électrodes de la paire (1) dont l'autre électrode (101) est réunie au premier pôle (+ $V_{cc}$) de la première source par l'intermédiaire d'une quatrième résistance (1000), caractérisé par le fait que l'émetteur du second transistor (12) est également réuni, par l'intermédiaire d'une cinquième résistance (17) formant avec la troisième résistance (1001) un second diviseur de tension résistif, au collecteur du premier transistor (11) et par le fait que les premier (15, 16) et second (17, 1001) diviseurs forment ensemble un pont résistif désequilibré, alimenté par le courant collecteur du premier transistor (11) et permettant, par le choix des valeurs respectives de ses quatre résistances constitutives (15, 16, 17, 1001), de programmer la sensibilité du basculeur bistable (10) (figure 1).

2. Commutateur électronique suivant la revendication 1, caractérisé par le fait que l'émetteur du premier transistor (11) dont la jonction base-émetteur (PN) est du même type que la jonction d'entrée de l'interrupteur (104), et relié à travers cette dernière au second pôle ( — Vcc) de la première source de sorte que l'état conducteur du basculeur (10) provoque la saturation de l'interrupteur (104) (figure 1).

3. Commutateur électronique suivant la revendication 1, caractérisé par le fait que l'interrupteur électronique (104) est constitué par un troisième transistor de commutation (104) du même type (NPN) que le premier (11) et par le fait que la base du troisième transistor (104) est directement reliée à l'émetteur du premier (11) et que son émetteur est relié au second pôle ( — Vcc) de la première source et également, lorsque le collecteur du troisième transistor (104) est réuni à travers une charge (109) à un premier pôle (+V$_L$) d'une seconde source de tension d'alimentation continue, au second pôle (−V$_L$) de cette seconde source.

4. Commutateur électronique à commande tactile du type comportant au moins deux interrupteurs èlectroniques (104, 204 ... m04) commandés chacun de façon alternée par un basculeur bistable (10, 20, ... n0) suivant l'une des revendications précédentes, dans lequel les émetteurs de tous les seconds transistors (12, 22,... n2) sont réunis ensemble à travers une résistance émetteur commune au premier pôle (+ Vcc) de la première source d'alimentation des basculeurs (10, 20,... n0), afin que l'activation de l'un des basculeurs non-activés par commande tactile entraîne la désactivation du basculeur activé antérieurement, caractérisé par la fait que la résistance commune réunissant les émetteurs au premier pôle est constituée par le montage parallèle de la résistance émetteur commune (1001) des seconds transistors (12, 22,... n2) et des autres résistances (n5, n6, n7) formant les ponts respectifs des basculeurs non-activés, connectés en série (figure 2).

5. Commutateur électronique suivant la revendication 4, du type comprenant un nombre N supérieur à quatre d'interrupteurs électroniques (104, 204, . . . n04) et de basculeurs bistables (10, 20,... n0) associés, caractérisé par le fait que la résistance commune reliant les émetteurs des seconds transistors (12, 22,... n2) à leur borne d'alimentation commune (1007), est constituée uniquement par les ensembles des trois résistances (n5, n6, n7) en série des N—1 basculeurs non-activés, connectés en parallèle, fournissant chacun une (N—1) -ième fraction du courant dont la somme alimente, d'une part, l'émetteur du second transistor (n2) du basculeur (n0) activé et, d'autre part, à travers sa cinquième résistance (n7), le collecteur du premier transistor (nl) de celui-ci (figure 3).

6. Sélecteur de canaux pour récepteur de télévision du type dans lequel les circuits résonnants des étages haute-fréquence et de l'oscillateur local comportent des diodes à capacité variable en fonction de leur tension de polarisation inverse, qui leur est appliquée du curseur de l'un d'une pluralité de potentiomètres (109,... n09) à travers une diode de découplage (112,... n15), les premières bornes des potentiomètres (109,... n9) étant reliées ensemble au premier pôle (+ V$_L$) d'une seconde source d'alimentation continue stabilisée (V$_L$), caractérisé par le fait que les secondes bornes des potentiomètres (109,... n09) sont reliés aux collecteurs (105,... n05) des transistors de commutation (104,... n04) dont les émetteurs sont reliés ensemble au second pôle (− V$_L$) de la seconde source et qui sont commandés par un commutateur électronique à commande tactile suivant l'une des revendications 4 et 5.

**Claims**

1. Electronic touch controlled switch of the kind in which galvanic contacting of a pair (1) of control electrodes (101, 102) insulated from each other and accessible to be touched, through skin resistance allows the closing of an active electronic semi-conductor interruptor (104) to be caused by applying a current to its input junction bringing the same into saturation, comprising a bistable storage flip flop (10) having two complementary transistors (11, 12) of high direct current transfer ratio, wherein the collector of the first transistor (11) is connected through a first resistive voltage divider (15, 16) to the first terminal ( + V$_{cc}$) of a first dc supply source, said first terminal being connected through a third resistor (1001) to the emitter of the second transistor (12), the base of which is connected to the central point (19) of the first divider (15, 16) and the collector of which is connected to the base of the first transistor (11) which is further connected to one (102) of the electrodes of the pair (1), the other electrode (101) of which is connected to the first terminal ( + V$_{cc}$) of the first source through a fourth resistor (1000), characterized by the fact that the emitter of the second transistor (12) is further connected to the collector of the first transistor (11) through a fifth resistor (17) forming a second resistive voltage divider with the third resistor (1001), and by the fact that the first (15, 16) and second (17, 1001) dividers together form an unbalanced resistive bridge fed by the collector current of the first transistor (11) and allowing the sensitivity of the bistable flip flop (10) to be programmed by selecting the respective values of the four resistors (15, 16, 17, 1001) of which it is formed (figure 1).

2. Electronic switch in accordance with claim 1, characterized by the fact that the emitter of the first transistor (11) the base emitter junction (PN) of which is of the same type as the input junction of the interruptor (104), is connected to the second terminal (−Vcc) of the first source through the latter, in such a manner that the conductive state of the flip flop (10) causes saturation of the interruptor (104) (figure 1).

3. Electronic switch in accordance with claim 1, characterized by the fact that the electronic interruptor (104) is formed by a third switching transistor (104) of the same type (NPN) as the first (11) and by the fact that the base of the third transistor (104) is directly connected to the emitter of the first (11) and that its emitter is connected to the second terminal (−Vcc) of the first source and further, when the collector of the third transistor (104) is connected to the first terminal ( + V$_L$) of a second dc supply source through a load (109), to the second terminal ( − V$_L$) of said second source.

4. Electronic touch controlled switch of the type having at least two electronic interruptors (104, 204, ... n04) each of which is alternately controlled by a flip flop (10, 20, ... n0), in accordance with any of the preceding claims, in which the emitters of all of the second transistors (12, 22, ... n2) are together connected to the first terminal ( + Vcc) of the first supply source of the flip flops (10, 20, ... n0) through a common emitter resistor so that activation of one of the deactivated flip flops by touch control will cause deactivation of the previously activated flip flop, characterized by the fact that the common resistor connecting the emitters to the first terminal is formed by the parallel connection of the common emitter resistor (1001) of the second transistors (12, 22, ... n2) and the other resistors (n5, n6, n7) forming the respective bridges of the deactivated flip flops, which are series connected (figure 2).

5. Electronic switch in accordance with claim 4, of the type comprising a number N exceeding 4 of electronic interruptors (104, 204, ... n04) and associated flip flops (10, 20, ... n0), characterized by the fact that the common resistor connecting the emitters of the second transistors (12, 22, ... n2) to their common supply terminal (1007) is formed only by the sets of three series resistors (n5, n6, n7) of the deactivated N—1 flip flops which are parallel connected and each of which delivers the (N—1)th fraction of the current the sum of which feeds the emitter of the second transistor (n2) of the activated flip flop (n0) on the one hand and, through its fifth resistor (n7), the collector of the first transistor (n1) thereof, on the other hand (figure 3).

6. Channel selector for television receiver of the type in which the resonant circuits of the high frequency stages and of the local oscillator comprise diodes of variable capacity with the capacity depending on their inverse polarisation voltage applied thereto from the wiper of one of a plurality of potentiometers (109, ... n09) through a decoupling diode (112, ... n15), the first terminals of the potentiometers (109, ... n09) being together connected to the first terminal ( + $V_L$) of a second continuous stabilized supply source ($V_L$), characterized by the fact that the second terminals of the potentiometers (109, ... n09) are connected to the collectors (105, ... n05) of the switching transistors (104, ... n04) the emitters of which are together connected to the second terminal (−$V_L$) of the second source and which are controlled by an electronic touch controlled switch in accordance with any of claims 4 and 5.

**Patentansprüche**

1.    Elektronischer    Umschalter    mit Berührungssteuerung, bei welchem die galvanische Verbindung eines Paares (1) von voneinander isolierten, der Berührung zugänglichen Steuerelektroden (101, 102) durch den Hautwiderstand das Schließen eines elektronischen aktiven Halbleiterunterbrechers (104) verursacht, indem an dessen eingangsseitigen Übergang ein Strom angelegt wird, der diesen in die Sättigung bringt, mit einer bistabilen Speicherkippschaltung (10), die zwei komplementäre Transistoren (11, 12) mit hohem Stromverstärkungsfaktor enthält, wobei der Kollektor des ersten Transistors (11) über einen ersten resistiven Spannungsteiler (15, 16) mit dem ersten Pol ( + Vcc) einer ersten Gleichspannungs-Versorgungsquelle verbunden ist, während dieser erste Pol über einen dritten Widerstand (1001) mit dem Emitter des zweiten Transistors (12) verbunden ist, dessen Basis an den Mittelpunkt (19) des ersten Teilers (15, 16) angeschlossen ist, und dessen Kollektor mit der Basis des ersten Transistors (11) verbunden ist, die ferner an die eine (102) der Elektroden des Paares (1) angeschlossen ist, dessen andere Elektrode (101) über einen vierten Widerstand (1000) mit dem ersten Pol ( + $V_{cc}$) der ersten Quelle verbunden ist, dadurch gekennzeichnet, daß der Emitter des zweiten Transistors (12) ferner über einen fünften Widerstand (17), der mit dem dritten Widerstand (1001) einen zweiten resistiven Spannungsteiler bildet, mit dem Kollektor des ersten Transistors (11) verbunden ist, und daß der erste Spannungsteiler (15, 16) und der zweite Spannungsteiler (17, 1001) gemeinsam eine unabgeglichene Widerstandsbrücke bilden, die von dem Kollektorstrom des ersten Transistors (11) gespeist ist und durch Wahl der jeweiligen Werte der vier Widerstände (15, 16, 17, 1001), aus denen sie gebildet ist, die Programmierung der Empfindlichkeit der bistabilen Kippschaltung (10) ermöglicht (Fig. 1).

2. Elektronischer Umschalter nach Anspruch 1, dadurch gekennzeichnet, daß der Emitter des ersten Transistors (11), dessen Basis-Emitter-Übergang (PN) vom selben Typ ist wie der eingangsseitige Übergang des Unterbrechers (104), über den letztgenannten Übergang mit dem zweiten Pol ( −Vcc) der ersten Quelle verbunden ist, so daß der leitende Zustand der Kippschaltung (10) die Sättigung des Unterbrechers (104) verursacht (Fig. 1).

3. Elektronischer Umschalter nach Anspruch 1, dadurch gekennzeichnet, daß der elektronische Unterbrecher (104) aus einem dritten Schalttransistor (104) des selben Typs (NPN) wie der erste (11) gebildet ist und daß die Basis des dritten Transistors (104) direkt mit dem Emitter des ersten (11) verbunden ist und sein Emitter mit dem zweiten Pol ( − Vcc) der ersten Quelle verbunden ist und ferner, wenn der Kollektor des dritten Transistors (104) über eine Last (109) mit einem ersten Pol ( + $V_L$) einer zweiten Gleichspannungs-Versorgungsquelle verbunden ist, mit dem zweiten Pol ( −$V_L$) dieser zweiten Quelle verbunden ist.

4. Elektronischer Umschalter mit Berühungssteuerung, welcher wenigstens zwei elektronische Unterbrecher (104, 204, ... n04) Berührungssteuerung, welcher wenigstens zwei elektronische Unterbrecher (104, 204, ... n04) umfaßt, die jeweils alternierend durch eine bistabile Kippschaltung (10, 20, ... n0) gesteuert sind, nach einem der vorstehenden Ansprüche, bei welchem die Emitter sämtlicher zweiter Transistoren (12, 22, ... n2) gemeinsam über einen gemeinsamen Emitterwiderstand mit dem ersten Pol (+ Vcc) der ersten Versorgungsquelle der Kippschaltungen (10, 20, ... n0) verbunden sind, damit die Aktivierung einer der nicht aktivierten Kippschaltungen durch Berührungssteuerung die Stillsetzung der zuvor aktivierten Kippschaltung bewirkt, dadurch gekennzeichnet, daß der gemeinsame Widerstand, welcher die Emitter mit dem ersten Pol verbindet, durch die Parallelschaltung des gemeinsamen Emitterwiderstandes (1001) der zweiten Transistoren (12, 22, ... n2) und der anderen Widerstände (n5, n6, n7), welche die jeweiligen Brücken der nicht aktivierten Kippschaltungen bilden, gebildet ist, die in Reihe geschaltet sind (Fig. 2).

5. Elektronischer Umschalter nach Anspruch 4, desjenigen Typs, welcher eine Anzahl N, die größer als 4 ist, von elektronischen Unterbrechern (104, 204, ... n04) und zugeordnete bistabile Kippschaltungen (10, 20, ... n0) umfaßt, dadurch gekennzeichnet, daß der gemeinsame Widerstand, welcher die Emitter der zweiten Transistoren (12, 22, ... n2) mit ihrem gemeinsamen Versorgungsanschluß (1007) verbindet, allein durch die Gruppen von drei in Reihe geschalteten Widerständen (n5, n6, n7) der N—1 nicht aktivierten, parallelgeschalteten Kippschaltungen gebildet ist, welche jeweils einen (N—1)-ten Bruchteil des Stromes bilden, dessen Summe zum einen den Emitter des zweiten Transistors (n2) der aktivierten Kippschaltung (n0) und zum anderen über ihren fünften Widerstand (n7) den Kollektor des ersten Transistors (n1) derselben speist (Fig. 3).

6. Kanalwähler für Fernsehempfänger, desjenigen Typs, bei welchem die Resonanzkreise der Hochfrequenzstufen und des Lokaloszillators Kapazitätsdioden mit in Abhängigkeit von ihrer Polarisationsspannung in Sperrichtung veränderlicher Kapazität enthalten, wobei diese Polarisationsspannung an sie aus dem Schleifer eines aus einer Mehrzahl von Potentiometern (109, ... n09) über eine entkopplungsdiode (112, ... n15) angelegt ist und wobei die ersten Anschlüsse der Potentiometer (109, ... n09) gemeinsam mit dem ersten Pol ($+V_l$) einer stabilisierten Gleichspannungsversorgungsquelle ($V_l$) verbunden sind, dadurch gekennzeichnet, daß die zweiten Anschlüsse der Potentiometer (109, ... n09) mit den Kollektoren (105, ... n05) der Schalttransistoren (104, ... n04) verbunden sind, deren Emitter gemeinsam mit dem zweiten Pol ($-V_l$) der zweiten Quelle verbunden sind und die von einem elektronischen Umschalter mit Berührungssteuerung nach einem der Ansprüche 4 und 5 gesteurert sind.

FIG_1

FIG_2

FIG_3